# EUROPEAN PATENT SPECIFICATION

(11) **EP 1 129 495 B1**
(45) Date of publication and mention of the grant of the patent: **23.08.2006**
(21) Application number: 99936468.0
(22) Date of filing: 01.07.1999
(51) Int. Cl.: H01L 43/06, H01L 27/22

(54) **INTEGRATED HALL DEVICE**
INTEGRIERTE HALLANORDNUNG
DISPOSITIF A EFFET HALL INTEGRE

(30) Priority: 02.07.1998 US 91534 P; 16.09.1998 US 100486 P
(43) Date of publication of application: 05.09.2001
(73) Proprietor: Austria Mikro Systeme International (AMS), 8141 Unterpremstätten (AT)
(72) Inventor: STEINER, Ralph, 8460 Marthalen (CH); OLBRICH, Thomas, A-8052 Graz-Wetzelsdorf (AT); KROENER, Friedrich, A-9500 Villach (AT)
(74) Representative: Frei, Alexandra Sarah
(86) International application number: PCT/EP1999/004557
(87) International publication number: WO 2000/002266

(56) References cited:
- EP-A- 0 735 600
- US-A- 5 572 058
- US-A- 5 831 513
- PARANJAPE M ET AL: "A CMOS-compatible 2-D vertical Hall magnetic-field sensor using active carrier confinement and post-process micromachining" SENSORS AND ACTUATORS A, vol. 53, no. 1, 1 May 1996 (1996-05-01), page 278-283 XP004018159 ISSN: 0924-4247
- PARANJAPE M ET AL: "INTEGRATED MICROMACHINED MAGNETIC FIELD SENSOR WITH ON-CHIP SUPPORTCIRCUITRY" APPLIED PHYSICS LETTERS, vol. 64, no. 12, 21 March 1994 (1994-03-21), pages 1576-1578, XP000434348 ISSN: 0003-6951

## Description

### Field of the invention

The invention is in the field of integrated micro systems, and concerns an integrated Hall device serving for measuring magnetic fields.

### Background of the invention

A Hall device usually has the form of a plate. This plate consists of conducting material and is provided with at least four electrical contacts at its periphery. A bias current is supplied to the device via two opposite contacts, called the current contacts. The two other contacts are placed at two equipotential points at the plate boundary. These contacts are called the voltage contacts or the sense contacts. If a magnetic field perpendicular to the surface is applied to the device, a voltage appears between the sense contacts due to the Hall effect. This voltage is called the Hall voltage.

Conventional integrated Hall devices have a Hall plate extending parallel to the structured substrate surface and therefore, are sensitive to magnetic inductions perpendicular to the chip surface. Such so called lateral Hall devices show excellent performance for many applications. However, in many other applications lateral devices cannot satisfy because of their sensitivity being restricted to the one magnetic induction component perpendicular to the chip surface.

An example of such an application is angle position detection with the aid of a permanent magnet whereby in order to determine the direction of the magnetic field, two components of the magnetic induction are advantageously measured simultaneously. Traditionally this is realized by using conventional lateral Hall plates each one of them measuring only one magnetic field component. This leads to a limitation of the angle measurement accuracy unless expensive multi-pole magnets and extensive signal processing are used in connection with the lateral Hall devices.

With an integrated Hall device sensitive parallel to the chip surface it is possible to implement a plurality of Hall plates on the same chip, the Hall plates not being parallel to each other but e.g. at right angles to each other. With only one chip comprising a plurality of correspondingly arranged Hall plates it is possible to measure two magnetic induction components parallel to the chip surface.

An integrated Hall device sensitive parallel to the chip surface is described in [1]. However, this so called vertical Hall device suffers from a strong cross-sensitivity due to insufficient carrier path confinement [2] and therefore cannot satisfactorily solve e.g. the above indicated problem regarding rotation position detection.

Sensors and Actuators, vol. 053, no. 1, May 1996, pages 278 - 283, discloses a set of Hall sensors with conducting regions extending into a chip surface and arranged to create carrier flows at right angles to one another. The conducting regions for a bias current are formed by confining carrier flow between, on the one hand, doped regions close to the chip surface, and on the other hand trenches etched deeper into the chip surface.

EP 0 735 600 A2 describes a lateral Hall element in which an isolation layer can be created alternatively by a p-n junction isolation layer or by dielectric isolation layer by trench element isolation.

It is therefore the object of the invention to create an integrated Hall device with a response to magnetic inductions parallel to the chip surface, which Hall device is to improve known integrated vertical Hall devices, in particular regarding the above mentioned cross-sensitivity or carrier path confinement respectively. Furthermore, the inventive integrated Hall device is to be manufacturable with manufacturing methods which are well known in the semiconductor industry.

This object is achieved by the Hall sensor as defined in the independent claim.

### Brief description of the invention

The integrated Hall device comprises a Hall plate which, compared with the Hall plate of a lateral integrated Hall device is rotated by 90°. The Hall plate of the inventive integrated Hall device extends as an active region substantially perpendicular to the substrate surface into the substrate, has one edge extending in the structured surface of the substrate and is separated from the rest of the substrate by at least two parallel trenches which are micromachined (e.g. etched) into the substrate from its structured surface or from its surface to be structured. For planarizing the structured substrate surface the trenches can be filled with a dielectric material.

The Hall plate of the inventive Hall device may be contacted on the one of its edges extending in the structured surface only. This contact arrangement renders processing simple and results in equivalent sensor performance. On the other hand, the contacts can be arranged at any place of the periphery of the Hall plate, in particular at its edge opposite the one extending in the substrate surface which edge is buried within the substrate. For such contacts, access pillars are provided, the access pillars being separated from the active area and from the rest of the substrate by micromachined trenches of the same type as the trenches for separating the active area from the substrate.

An inventive integrated Hall sensor comprising two Hall plates at right angles to each other can be manufactured with the same method and is able to serve for measuring two perpendicular components of magnetic induction, as desired for angle position detection with the aid of a permanent magnet.

The inventive integrated Hall device is produceable using the manufacturing method reported in [3]. The approach is close to state-of-the-art industrial low-cost manufacturing of integrated microsystems.

Other than the known vertical Hall devices according to [1], the inventive Hall device (so called trench-Hall device) shows very small cross-sensitivity because the active region defined by two parallel trenches can be made very thin (e.g. 2,4 µm). Additionally, the inventive Hall device offers the possibility of dynamic offset compensation. Therefore, for applications where the absolute value of the measured magnetic field is of interest, use of the inventive Hall device is advantageous, although due to necessary additional process steps, the trench-Hall device may be more costly than a known vertical Hall device.

A major advantage of the inventive Hall device is the fact that it can be manufactured with complete compatibility to a CMOS process. Fabrication of the inventive Hall device comprises a step of trench-etching followed by a set of CMOS steps according the method described in [3]. Consequently, front-end electronics for operation of the Hall device can be co-integrated on the same chip enabling an accurate and inexpensive microsystem for magnetic field measurements.

Summarizing, the inventive Hall device combines the following advantages:
- The proposed fabrication technology (according to [3]) enables co-integration of Hall devices and dedicated electronics on the same chip but electrically completely insulated.
- The proposed fabrication technology (according to [3]) enables cheap high volume production in, e.g., a CMOS process.
- For simultaneous measuring of two components of a magnetic field the Hall device shows an excellent cross-sensitivity due to the thin active area defined by two parallel trenches.
- Dynamic offset compensation according to [4] is applicable.
- The performance of the sensor can be arbitrarily shaped by the geometry and the doping concentration of the active region without changing the parameters of the dedicated electronics on the same chip.
- The active region can be contacted at any location without changing the operating principle of the Hall device.

### Brief description of the Figures

The inventive integrated Hall device is described in further detail in connection with the appended Figures of which:
- **Figure 1**: shows an inventive integrated Hall device applicable for rotation position detection with the aid of a permanent magnet;
- **Figure 2**: shows schematically a conventional integrated Hall device as well as the principle and two preferred embodiments of the inventive integrated Hall device;
- **Figure 3**: shows a three dimensional and sectioned representation of an embodiment of the inventive integrated Hall device with a buried contact to the active region;
- **Figure 4**: shows the magnetic response of the inventive Hall device according to Figure 3 at a biasing current of 100 µA and the corresponding linearity error;
- **Figure 5**: shows a photograph of the structured substrate surface of an inventive integrated Hall device with an orthogonal arrangement of two Hall plates;
- **Figure 6**: shows the angular field dependence of two orthogonal trench-Hall devices integrated on the same chip as shown in Figure 5 and the corresponding signal deviations from sine and cosine fits.

### Detailed description of the invention

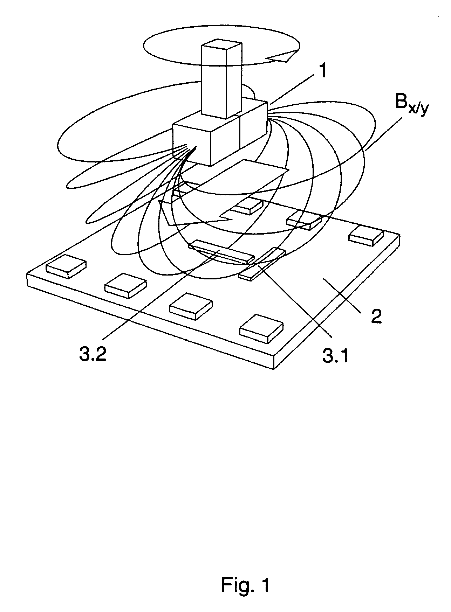

Fig. 1 shows an angle detection system with a permanent magnet 1 in combination with an inventive integrated device 2 which for measuring the two components Bx and By of the magnetic induction parallel to the chip surface comprises two Hall devices 3.1 and 3.2 with active regions serving as Hall plates being oriented at right angles to each other. The measurement with the system illustrated in Figure 1 is insensitive to the field magnitude and to the position of the Hall devices in relation to the rotation axis of the permanent magnet.

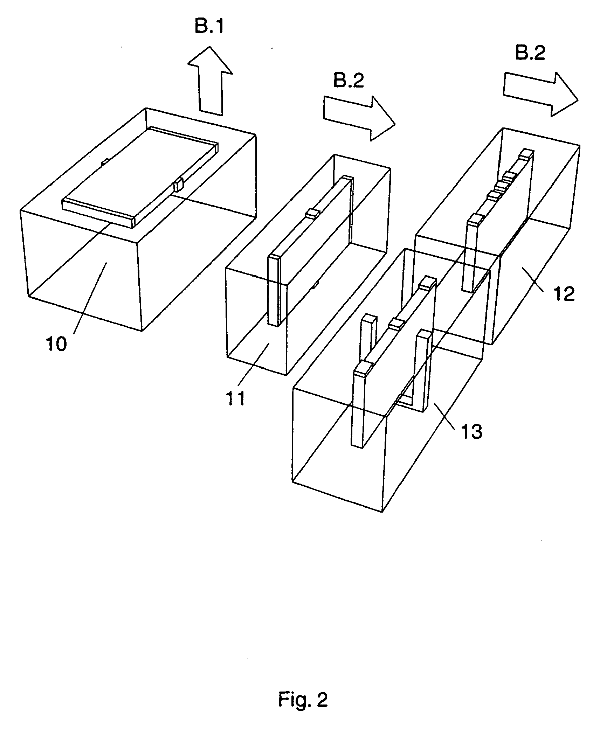

Fig. 2 shows a conventional lateral Hall device 10 being sensitive to magnetic induction perpendicular to the chip surface (B.1), for illustrating the principle of the inventive Hall device, a vertical Hall device 11 resulting from turning the active region of the device 10 by 90° and resulting in a sensitivity parallel to the chip surface (B.2) and two preferred embodiments 12 and 13 of the inventive Hall device, the one (12) with contacts at the chip surface only, the other one (13) with contacts at the chip surface (structured substrate surface) and with buried contacts.

Arranging all contacts at the chip surface renders the manufacturing process simpler but results in design constraints concerning a symmetric device geometry. These constraints are eliminated by introducing buried contacts, which allow the design of a vertical Hall device being invariant under a rotation of π/2. In terms of spinning current, this results in a more effective offset reduction.

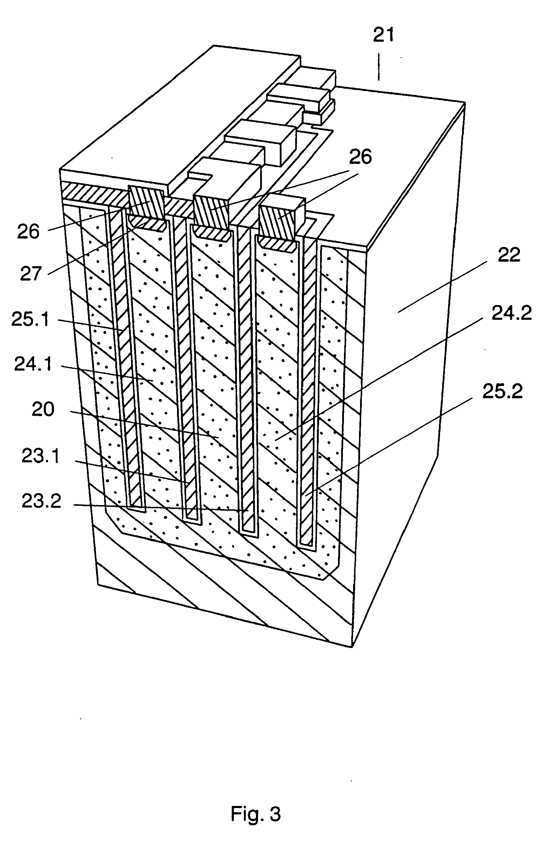

Fig. 3 shows as a more detailed three dimensional and sectioned representation of the embodiment 13 of the inventive Hall device. This device comprises an active region 20 extending perpendicular to the structured substrate surface 21 into the substrate 22 and being defined by at least two parallel trenches 23.1 and 23.2 and it further comprises two contact pillars 24.1 and 24.2 connecting the buried edge of the active region 20 to the structured chip surface and being separated from the active area 20 by the trenches 23.1 and 23.2 and from the rest of the substrate by further similar trenches 25.1 and 25.2. The surface contacts 26 to the surface edge of the active region and to the contact pillars are completed in a CMOS process (source/drain diffusions 27).

Preferably, the active region 20 is as thin as possible, i.e. has a thickness which is up to a hundred times smaller than its extension perpendicular to the chip surface (depth of the trenches).

The substrate 22 is e.g. a p-doped silicon substrate. The drive-in of the pre-deposited donors for the active region 20 and for the access pillars 24.1 and 24.2 (indicated as hatched and dotted area) occurs simultaneously with the transistor-well formation.

The manufacturing scheme for a preferred embodiment of the inventive Hall device as e.g. illustrated by Figure 3 consists of various pre-processing steps followed by an industrial CMOS-process. The pre-processing mainly comprises high temperature steps required for the Hall device fabrication, these steps only being compatible with the thermal budget of the CMOS process if performed in advance. The main pre-processing step is the etching of the trenches (e.g. similar step as used in fabrication of DRAM memory cells). In subsequent processing electrical contacts for the active region are defined and front-end electronics for sensor operation can be co-integrated. In order to design the front-end electronics the entire design environment of the particular CMOS process is accessible.

Manufacturing starts with the deposition of a hard-mask on a silicon substrate. The hard mask is a sandwich of dielectric CMOS layers according to the method described in [3]. The hard mask serves two purposes: first, as a mask for the trench etching, and second, to protect the region of the silicon substrate not used for Hall devices. The hard mask is opened by plasma etching. Then, parallel trenches and if applicable trenches for access pillars are etched to a depth of e.g. up to about 20 µm. The parallel trenches defining the active area have a width of, e.g., 0.8 µm and a distance from each other of, e.g., 2.4 µm (thickness of the active region).

All side-walls of the trenches are doped by ion-implantation [3]. With this unique method of trench etching, followed by ion-implantation, a pre-deposition depth of over 20 µm is achieved without a time consuming drive-in from the chip surface. Additionally, the ion-dose can be arbitrarily chosen to optimize the performance of the trench-Hall device. Therefore, the parameters of the co-integrated electronics are not affected. The drive-in of the pre-deposited donors occurs simultaneously with the transistor well formation in the CMOS process that follows pre-processing [3].

As a next step, the trenches are oxidized for insulation. A highly n-doped polysilicon (or other dielectric material) is deposited in the trenches, mainly serving for planarizing the trench grooves. Additionally, the polysilicon serves as an electrical shield to improve the EMC of the trench-Hall device. The polysilicon is patterned and etched back by plasma etching. As a result, a polysilicon paddle is formed which allows electrically connecting the trench polysilicon in later processing steps. Finally the rest of the hard mask is removed by wet etching to terminate pre-processing. The wafers with the finished pre-processed trench-Hall device or devices serve as a starting substrate for the CMOS process.

In the CMOS processing, the drive-in for the active region and the access pillars occurs simultaneously with the transistor-well formation. As a result, a homogeneously doped active region is achieved with a depth of up to 20 µm and with a thickness of e.g. approximately 2.4 µm. Furthermore, the electrical contacts of the Hall device are formed by source/drain diffusions.

Measuring characteristics of the device according to Figure 3 and produced as described above are as follows:

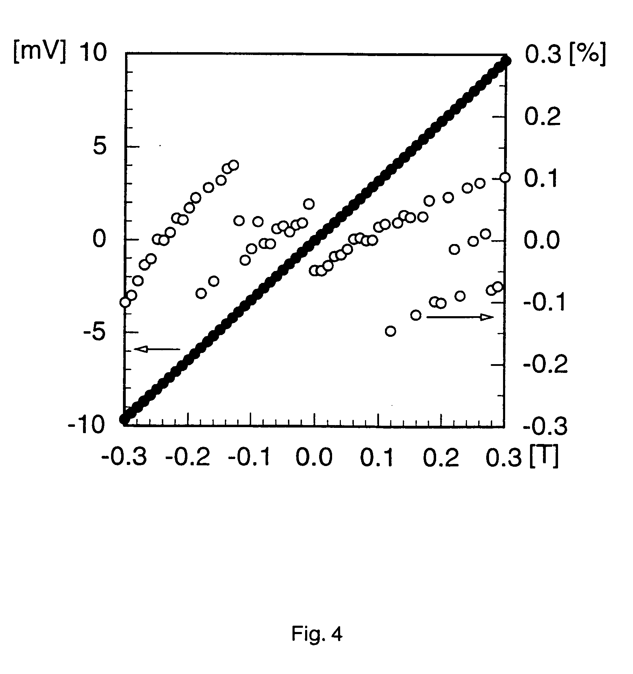

The current related sensitivity of the device was determined to be 314 V/AT. This value is in the range of the sensitivity of a conventional lateral Hall device. However, the sensitivity can be arbitrarily adjusted by the ion-dose without changing any electrical parameters of co-integrated electronics. As shown in Figure 4, which shows the response in mV to magnetic induction of up to 0.3 T at a biasing current of 100 µA, the signal deviation from a linear fit lies below 0.15%.

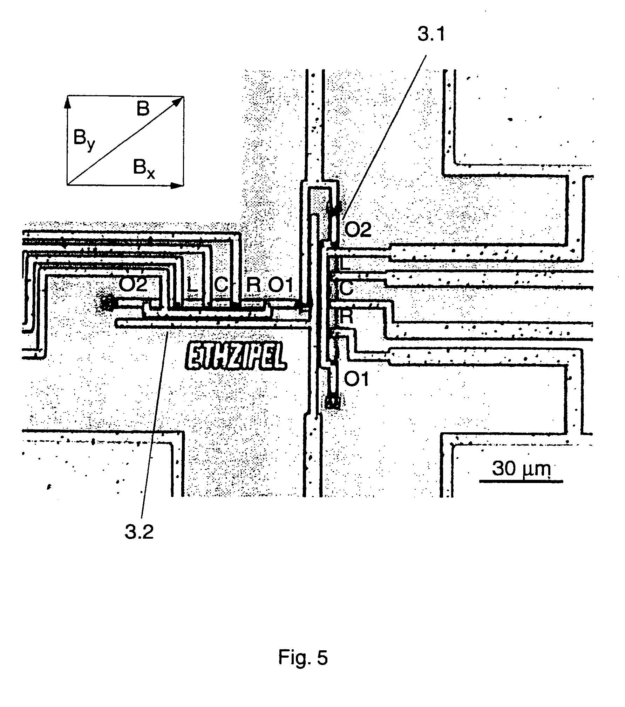

Figure 5 is a photograph of the structured substrate surface of a realized inventive Hall device as sketched in Figure 1. This device comprises two Hall devices 3.1 and 3.2 each according to the principle of the device 12 of Figure 2, i.e having surface contacts only. Each of the Hall devices has an active region, the two active regions being oriented at right angles to each other. Each sensor 3.1 and 3.2 is biased at the contacts C, O1 and 02. The respective Hall voltages are measured at the contacts L and C

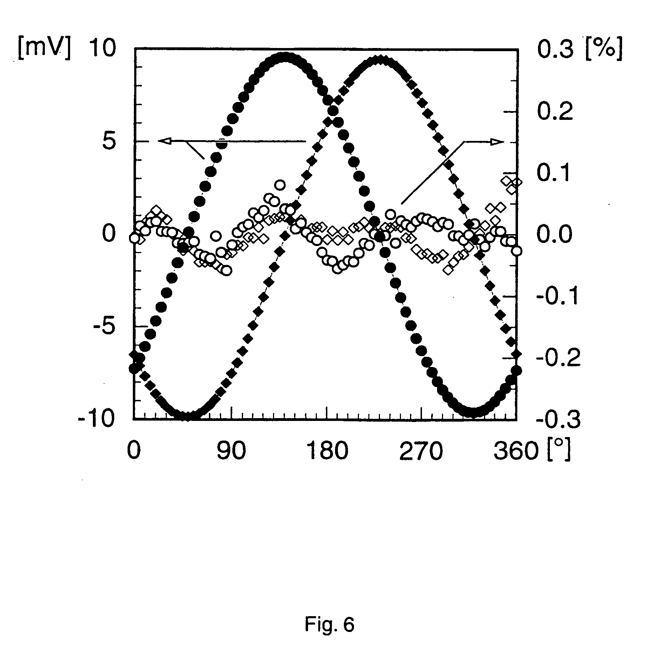

In order to determine the cross-sensitivity of the device pictured in Figure 5 the response of the two Hall devices 3.1 and 3.2 were measured while the magnetic induction parallel to the chip surface was rotated. Figure 6 shows cross-sensitivity and linearity errors for a magnetic induction of 0.3 T resulting in a signal deviation from a sine-/cosine-function below 0.1 %. This is expressed in terms of an equivalent angular error of approximately 0.1°. These deviations are due to a combination of non-linearity and cross-sensitivity.

The trench-Hall device can be dynamically offset compensated by means of current spinning [4]. Measurements of ten devices showed residual offsets from 0.1 to 1.0 mT.

### References

[1] R.S. Popovic, "The vertical Hall-effect device," IEEE Electron Device Lett., vol. EDL-5, p. 357, 1984.
[2] C.S. Roumenin, "Parallel-field Hall microsensors: an overview," Sensors and Actuators A, vol. 30, no. 1-2, p. 77, 1992.
[3] Austria Mikro Systeme International, "Verfahren zur Herstellung von begrenzten, dotierten Teilgebieten in einem Substratmaterial aus monokristallinem Silizium," Austrian Patent No. GM378/97, 1997.
[4] P. Munter, "A low offset spinning-current Hall plate," Sensor and Actuators A, vol. 21-23, p. 743, 1990.

## Claims

1. Hall device comprising a plate-like active region (20) integrated in a doped silicon substrate (22) with a structured substrate surface (21) and being contacted by at least two bias contacts for supplying a bias current to the active region and by at least one sense contact being connected or connectable to means for detecting and quantifying a Hall voltage, wherein for being sensitive to a magnetic field component parallel to the structured substrate surface (21), the active region (20) extends perpendicular to the structured substrate surface (21) and has an edge extending in the structured substrate surface (21), and wherein the active region (20) is separated from the rest of the substrate (22) by at least two parallel trenches (23.1 and 23.2), **characterized in that** the distance between the parallel trenches (23.1 and 23.2) defines the thickness of the active region (20), **in that** the active region (20) is doped by doping the side walls of the trenches and by this doping is electrically insulated from the rest of the substrate (22) by a p/n-junction, and **in that** said trenches for planarization of the structured substrate surface (21) are filled.

2. Hall device according to claim 1, **characterized in that** the depth of the at least two parallel trenches (23.1 and 23.2) is up to 100 times greater than the distance between the parallel trenches (23.1 and 23.2).

3. Hall device according to one of claims 1 to 2, **characterized in that** it comprises integrated on the same substrate a further Hall device (3.2) with an active region being oriented perpendicular to the structured substrate surface and perpendicular to the to the active region of the first Hall device (3.1).

4. Hall device according to one of claims 1 to 3, **characterized in that** the means for detecting and quantifying the hall voltage is integrated on the same substrate.

5. Hall device according to one of claims 1 to 4, **characterized in that** the active region (20) is contacted at the one edge extending in the structured substrate surface (21).

6. Hall device according to claim 5, **characterized in that** the active region (20) is in addition contacted in an area buried in the substrate (22) with at least one additional contact comprising an access pillar (24.1 and 24.2) connecting the buried area with the structured substrate surface (21) and being separated from the rest of the substrate (22) and from the active region (20) by trenches (23.1/2, 25.1/2) filled in order to planarize the structured substrate surface (21).

7. Hall device according to one of claims 1 to 6, **characterized in that** the trenches (23.1/2, 25.1/2) are oxidized for insulation and **in that** the material with which the trenches (23.1/2, 25.1/2) are filled is highly doped and serves as an electrical shield.

## Patentansprüche

1. Hall-Einrichtung mit einer plattenartigen aktiven Zone (20), die in ein dotiertes Siliziumsubstrat (22) mit einer strukturierten Substratoberfläche (21) integriert ist und die von mindestens zwei Vorspannungskontakten kontaktiert ist, über welche ein Vorspannungsstrom der aktiven Zone zuführbar ist, und von mindestens einem Sensorkontakt, der mit einer Einrichtung zur Detektion und Quantifizierung einer Hall-Spannung verbunden oder verbindbar ist, wobei die aktive Zone, um auf eine magnetische Feldkomponente parallel zur strukturierten Substratoberfläche (21) empfindlich zu sein, senkrecht zur strukturierten Substratoberfläche (21) verläuft und einen Rand hat, der sich in der strukturierten Substratoberfläche (21) erstreckt, und wobei die aktive Zone (20) von dem Rest des Substrates (22) durch mindestens zwei parallelen grabenartigen Ausnehmungen (23.1 und 23.2) getrennt ist, **dadurch gekennzeichnet, daß** die Entfernung zwischen den parallelen grabenartigen Ausnehmungen (23.1 und 23.2) die Dicke der aktiven Zone (20) definiert und daß die aktive Zone (20) durch Dotierung der Seitenwände der grabenartigen Ausnehmungen dotiert ist und durch diese Dotierung elektrisch vom Rest des Substrates (22) durch einen p/n-Übergang isoliert ist, und daß die grabenartigen Ausnehmungen zur Planarisierung der strukturierten Substratoberfläche (21) ausgefüllt sind.

2. Hall-Einrichtung nach Anspruch 1, **dadurch gekennzeichnet, daß** die Tiefe der mindestens zwei parallelen grabenartigen Ausnehmungen (21.1 und 23.2) bis zu einhundert Mal größer als die Entfernung zwischen den parallelen grabenartigen Ausnehmungen (23.1 und 23.2) ist.

3. Hall-Einrichtung nach einem der Ansprüche 1 bis 2, **dadurch gekennzeichnet, daß** sie auf demselben Substrat integriert eine weitere Hall-Einrichtung (3.2) umfaßt, deren aktive Zone senkrecht zur strukturierten Substratoberfläche und senkrecht zur aktiven Zone der ersten Hall-Einrichtung (3.1) ausgerichtet ist.

4. Hall-Einrichtung nach einem der Ansprüche 1 bis 3, **dadurch gekennzeichnet, daß** die Einrichtung zum Detektieren und Quantifizieren der Hall-Spannung auf demselben Substrat integriert ist.

5. Hall-Einrichtung nach einem der Ansprüche 1 bis 4, **dadurch gekennzeichnet, daß** die aktive Zone (20) an dem einen Rand kontaktiert ist, der in der strukturierten Substratoberfläche (21) verläuft.

6. Hall-Einrichtung nach Anspruch 5, **dadurch gekennzeichnet, daß** die aktive Zone (20) zusätzlich in einer Fläche kontaktiert ist, die in dem Substrat (22) eingebettet ist, wobei mindestens ein zusätzlicher Kontakt eine Zugangssäule (24.1 und 24.2) umfaßt, welche die eingebettete Fläche mit der strukturierten Substratoberfläche (21) verbindet und von dem Rest des Substrates (22) und von der aktiven Zone (20) durch grabenartige Ausnehmungen (23.1/2, 25.1/2) getrennt ist, die zur Planarisierung der strukturierten Substratoberfläche (21) gefüllt sind.

7. Hall-Einrichtung nach einem der Ansprüche 1 bis 6, **dadurch gekennzeichnet, daß** die grabenartigen Ausnehmungen (23.1/2, 25.1/2) zur Isolation oxidiert sind und daß das Material, mit dem die grabenartigen Ausnehmungen (23.1/2, 25.1/2) gefüllt sind, hoch dotiert ist und als elektrische Abschirmung dient.

## Revendications

1. Dispositif à effet Hall comprenant une région active en forme de plaque (20) intégrée dans un substrat en silicium dopé (22) ayant une surface de substrat structurée (21) et étant touché par au moins deux contacts de polarisation afin de fournir un courant de polarisation à la région active et par au moins un contact de détection relié ou pouvant être relié à un moyen permettant de détecter et de quantifier une tension de Hall, dans lequel, afin d'être sensible à une composante de champ magnétique parallèle à la surface de substrat structurée (21), la région active (20) s'étend perpendiculairement à la surface de substrat structurée (21) et possède un bord s'étendant dans la surface de substrat structurée (21), et dans lequel la région active (20) est séparée du reste du substrat (22) par au moins deux tranchées parallèles (23.1 et 23.2), **caractérisé en ce que** la distance entre les tranchées parallèles (23.1 et 23.2) définit l'épaisseur de la région active (20), **en ce que** la région active (20) est dopée en dopant les parois latérales des tranchées et, grâce à ce dopage, est électriquement isolée du reste du substrat (22) par une jonction p/n, et **en ce que** lesdites tranchées de planarisation de la surface de substrat structurée (21) sont remplies.

2. Dispositif à effet Hall selon la revendication 1, **caractérisé en ce que** la profondeur des deux tranchées parallèles au moins (23.1 et 23.2) est jusqu'à 100 fois supérieure à la distance entre les tranchées parallèles (23.1 et 23.2).

3. Dispositif à effet Hall selon l'une des revendications 1 à 2, **caractérisé en ce qu'**il comprend, intégré sur le même substrat, un autre dispositif à effet Hall (3.2) ayant une région active orientée perpendiculairement à la surface de substrat structurée et perpendiculairement à la région active du premier dispositif à effet Hall (3.1).

4. Dispositif à effet Hall selon l'une des revendications 1 à 3, **caractérisé en ce que** le moyen permettant de détecter et de quantifier la tension de Hall est intégré sur le même substrat.

5. Dispositif à effet Hall selon l'une des revendications 1 à 4, **caractérisé en ce que** la région active (20) est touchée au niveau d'un bord s'étendant dans la surface de substrat structurée (21).

6. Dispositif à effet Hall selon la revendication 5, **caractérisé en ce que** la région active (20) est en outre touchée dans une zone enfouie dans le substrat (22) avec au moins un contact supplémentaire comprenant un point d'accès (24.1 et 24.2) reliant la zone enfouie à la surface de substrat structurée (21) et étant séparé du reste du substrat (22) et de la région active (20) par des tranchées (23.1/2, 25.1/2) remplies afin de planariser la surface de substrat structurée (21).

7. Dispositif à effet Hall selon l'une des revendications 1 à 6, **caractérisé en ce que** les tranchées (23.1/2, 25.1/2) sont oxydées pour des raisons d'isolation, et **en ce que** le matériau avec lequel les tranchées (23.1/2, 25.1/2) sont remplies est hautement dopé et sert de blindage électrique.
